# FASCICULE DE BREVET EUROPEEN

(11) **EP 3 835 452 B1**
(45) Date de publication et mention de la délivrance du brevet: **31.01.2024**
(21) Numéro de dépôt: 19214570.4
(22) Date de dépôt: 09.12.2019
(51) Int. Cl.: C23C 14/06, C23C 14/58, B44C 1/00, C23C 14/00, C23C 14/34, A44C 27/00, B23K 26/0622, G04B 19/04, G04B 19/12, G04B 37/22, G04D 3/00, B23K 26/352

(54) **METHODE DE FABRICATION D'UNE SURFACE DECORATIVE**
HERSTELLUNGSVERFAHREN EINER DEKOROBERFLÄCHE
METHOD FOR MANUFACTURING A DECORATIVE SURFACE

(43) Date de publication de la demande: 16.06.2021
(73) Titulaire: The Swatch Group Research and Development Ltd, 2074 Marin (CH)
(72) Inventeur: MANASTERSKI, Christian, 2019 Rochefort (CH); GSTALTER, Marion, 25570 Grand'Combe Châteleu (CH)
(74) Mandataire: ICB SA

(56) Documents cités:
- CH-A1- 714 234
- US-A- 5 176 890
- C. MITTERER ET AL: "Structure and properties of decorative rare-earth hexaboride coatings", SURFACE AND COATINGS TECHNOLOGY, vol. 86-87, 1 décembre 1996 (1996-12-01), pages 715-721, XP055703493, AMSTERDAM, NL ISSN: 0257-8972, DOI: 10.1016/S0257-8972(96)02971-4

## Description

### Domaine technique

L'invention concerne le domaine de la fabrication de surfaces décoratives pour des objets de luxe, tels que les montres ou les bijoux. L'invention concerne plus particulièrement l'utilisation de l'hexaborure de lanthane (LaB₆) pour la production de ces surfaces décoratives.

### Arrière-plan technologique

L'hexaborure de lanthane fait partie des terres rares. Compte tenu de son « travail de sortie » (work-function) très bas, soit environ 2.4 eV, ce matériau est couramment utilisé dans le domaine de l'électronique. Une des utilisations principales est la fabrication de cathodes chaudes.

La stoechiométrie LaB₆ a une couleur intense pourpre violet, et les stoechiométries avoisinantes peuvent prendre par exemple des couleurs bleues ou vertes. Cette céramique a une dureté très élevée (environ 2500 HV), et une haute résistance à la corrosion.

La publication de C. Mitterer et Al. intitulée « Structure and properties of décorative rare-earth hexaboride coatings » dans l'ouvrage SURFACE AND TECHNOLOGY, vol. 86-87 du 1er décembre 1996 pages 715-721, XP055703493, Amsterdam, NL ISSN : 0257-8972, DOI: 10.1016/S0257-8972 décrit différentes techniques de dépôts PVD pour le dépôt de revêtements décoratifs à base d'hexaborures de terres rares.

Le document CH714234 quant à lui décrit un procédé de fabrication d'une pièce, notamment pour l'horlogerie ou la joaillerie avec une surface comprenant du titane coloré par oxydation.

### Résumé de l'invention

Selon la présente invention, une couche de borure de lanthane de stoechiométrie LaBₓ est déposée sur un substrat, par exemple un cadran en inox d'une montre, et ensuite traitée par un laser, de manière à modifier ladite stoechiométrie de la ladite portion de la couche de LaBₓ soumise au traitement laser en LaB_{y} et lui conférer une couleur ladite couleur obtenue étant déterminée par les paramètres du laser. Le passage de LaBx en LaBy se fait en ajustant les paramètres du laser. Les paramètre du laser sont notamment la durée des impulsions, la puissance moyenne du faisceau laser, l'énergie par impulsions, la fréquence de répétition, le diamètre du spot, le recouvrement des spots en direction longitudinale et transversale et la fluence par impulsion.

Avantageusement, la couche LaBₓ est transformée par le traitement laser en LaB_{y} avec y compris entre 9 et 12.

Cette méthode permet de produire des surfaces multicolores ayant une haute résistance à la corrosion et à l'abrasion. De préférence, la couche de LaBₓ est déposée par PVD (Physical Vapour Déposition), et préférentiellement par pulvérisation cathodique, à partir d'une cible de LaB₆ de couleur pourpre violet, de sorte que la couleur de la couche déposée diffère de la couleur de la cible. Le traitement laser à des puissances spécifiques change la stoechiométrie de la couche dans les portions traitées, de sorte que la couleur de ces portions change en fonction de la stoechiométrie obtenue. A des puissances plus élevées, le laser va essentiellement enlever la couche LaBₓ, de sorte que la couleur des portions traitées est déterminée par le matériau du substrat.

L'invention concerne également un objet décoratif produit par la méthode de l'invention, notamment un objet comportant un substrat pourvu d'une couche, la couche comprenant au moins deux portions de couleurs différentes l'une par rapport à l'autre, les portions consistant au moins à leur surface de borure de lanthane déterminé par des stoechiométries de borure de lanthane différentes dans les différentes portions. De préférence, une des portions de la surface de ladite couche comprend un LaB_{y} avec y compris entre 9 et 12.

### Description détaillée de l'invention

Une forme d'exécution détaillée de l'invention sera décrite ci-dessous. Cette forme d'exécution ne limite pas la portée de l'invention, mais sert uniquement d'exemple d'une mise en oeuvre de la méthode selon l'invention.

La cible est préparée par le dépôt de LaBₓ avec x=6 sous forme d'une poudre de couleur pourpre violette sur une semelle, de préférence en cuivre. La poudre est frittée et brasée sur la semelle, de sorte qu'une couche solide, toujours de couleur pourpre violette, soit formée sur la semelle, qui peut servir comme cible pour l'application d'un dépôt PVD par pulvérisation cathodique. Typiquement l'épaisseur de la couche solide est de l'ordre de 500 nm (0.5 µm) Des semelles pourvues de LaB6 et préparées d'avance sont disponibles pour des applications PVD. Dans l'exemple de la méthode décrite ci-après, les inventeurs ont utilisé une semelle pourvue d'une couche circulaire de LaB₆ ayant un diamètre d'environ 75 mm.

Un substrat en inox de 20 mm X 30 mm est introduit dans un réacteur du type RF-CCP (Radio-Frequency Capacitively Coupled Plasma), et est placé sur une plateforme à l'intérieur de la chambre du réacteur. Le réacteur comporte un support apte à maintenir la cible et une source RF standard. Le réacteur est pourvu de moyens pour réduire et réguler la pression à l'intérieur de la chambre, et des moyens pour introduire un flux d'un fluide gazeux, tel que l'argon, dans la chambre.

Dans l'exemple actuel, le réacteur est opéré en mode confocal. Ceci implique que la cible est placée sous un angle de préférence de 30° par rapport à l'axe central et perpendiculaire à la plateforme. La plateforme est montée de manière rotative et peut tourner autour de cet axe central.

Une étape de nettoyage du substrat est d'abord effectuée, en le soumettant à un processus de décapage (etching), par l'intermédiaire par exemple d'un plasma à l'argon créé dans la chambre du réacteur, après l'installation de la cible. Les paramètres de cette étape de décapage sont par exemple les suivants : pression 1.5 10⁻² mbar ; durée 5 min ; tension d'accélération 600 V.

Puis, la cible est utilisée dans le support de manière à jouer le rôle de cathode lors du dépôt PVD, et de sorte que la distance entre la cible et le centre du substrat soit typiquement de 110 mm. Le dépôt d'une couche de borure de lanthane d'environ 500 nm d'épaisseur par PVD en argon, via pulvérisation cathodique de la cible, a lieu sous les conditions typiques suivantes :
- Puissance appliquée sur la cathode : 250 W (soit 404 V pour 0.62 A en mode DC)
- Pression Ar : 3 µbar.
- Température de dépôt : 430 °C (cette température est un set point programmé sur la machine, et non pas la température réelle mesurée sur le substrat).
- Biais appliqué à la cathode par rapport au substrat : - 150V DC
- Temps de déposition : 1500 secondes pour obtenir 300 nm (0.2 à 0.25 nm/s).
- Vitesse de rotation du substrat : environ 10 tours/minute

On constate que la couleur de la couche déposée diffère de la couleur pourpre-violette de la cible. La couleur de la couche déposée est gris-bleu ardoise. L'explication de cette différence de coloration est fournie par l'analyse SEM-EDX de la couche. Il ne s'agit plus d'une couche de stoechiométrie LaB₆ comme la cible, mais d'une stoechiométrie LaB₉ à LaB₁₂, appelée ci-après LaBy. En effet, les vitesses de pulvérisation du lanthane et du bore sont différentes, ce qui conduit à une couche enrichie en bore et donc appauvrie en lanthane.

Selon l'invention, le traitement local au laser, de la couche déposée par PVD, va changer à nouveau la couleur de la couche. Un laser de marquage est utilisé opérant dans le domaine de l'infra-rouge. Le laser est commandé afin de balayer un spot sur une portion prédéfinie de la surface de la couche de LaBₓ. En fonction des paramètres appliqués, trois couleurs différentes peuvent être obtenues sur des zones adjacentes du même substrat : bleu, violet et gris-blanc, de manière à obtenir un motif multicolore sur le substrat. La table suivante divulgue les paramètres typiques appliqués dans les trois cas.

| Couleurs obtenues | bleu | Violet | Gris-blanc |
|---|---|---|---|
| 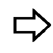 | | | |
| Paramètres appliqués | | | |
| 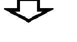 | | | |
| Durée des impulsions | 4 ns | 8 ns | 4 ns |
| Puissance moyenne | 8 à 10 W | 5.2 W | 18 à 20 W |
| Energie par impulsion | 40 à 100 µJ | 11.6 µJ | 90 à 135 µJ |
| Fréquence de répétition | 100 à 200 kHz | 400 à 500 kHz de préférence 450 kHz | 150 à 200 kHz |
| Diamètre du spot | 68 µm | 68 µm | 68 µm |
| Recouvrement des spots en direction longitudinale et transversale | 70 & 85% | 97 & 98% | 80 & 85% |
| Fluence par impulsion | 1.2 à 2.8 J/cm2 | 0.30 à 0.34 J/cm2 de préférence 0.32 J/cm2 | 2.5 à 3.7 J/cm2 |

On a constaté que c'est en premier lieu la puissance du laser qui définit la couleur obtenue. Les différences au niveau de la fréquence, du recouvrement et de la durée des impulsions n'influencent que peu ou pas la couleur, mais peuvent résulter en des nuances différentes de la même couleur.

Une analyse SEM-EDX a établi que les couches bleues et violettes sont constituées de stoechiométries spécifiques de borure de lanthane qui déterminent les couleurs en question. Par contre, la couche gris-blanc contient peu de bore et de lanthane, mais sa couleur est déterminée par la présence de Fe et Ni du substrat inox. Ceci veut dire que la couche de LaBy a essentiellement été enlevée ou partiellement enlevée et que la couleur est déterminée principalement par la couleur du substrat.

Une série de nano-indentations a pu montrer que la couche déposée par PVD avait une dureté d'environ 2500 HV, et qu'après traitement laser elle conservait une dureté de 1500 HV pour le violet et 1000 HV pour le bleu, ce qui est suffisant pour des applications horlogères exposées à l'abrasion. D'autre part un test « climat tropical » soit exposition dans une enceinte à une température de 60°C, avec une HR% de 90% pendant 7 jours, a montré que le revêtement n'était nullement affecté.

Ainsi, de manière non limitative et dès lors que le spot laser ne traverse pas la couche de LaBₓ, il est possible de décorer selon cette méthode un composant horloger comme, un cadran horloger, des aiguilles, une boite de montre, un élément de fermoir ou un maillon de bracelet.

Bien entendu, la présente invention ne se limite pas à l'exemple illustré mais est susceptible de diverses variantes et modifications qui apparaîtront à l'homme de l'art. En particulier, l'invention ne saurait se limiter à une pièce d'habillage horloger ou même au domaine horloger. Ainsi, à titre d'exemple, rien n'empêche d'utiliser la méthode selon l'invention pour une application dans le domaine des arts de la table, de la bijouterie, de la joaillerie, de la maroquinerie ou encore des instruments à écrire.

## Revendications

1. Méthode de fabrication d'une surface décorative sur un substrat, **caractérisée en ce que** la méthode comprend les étapes suivantes :
• déposer une couche de LaBₓ sur le substrat ayant une première stoechiométrie,
• soumettre au moins une portion de la couche de LaBₓ à un traitement laser, de manière à modifier ladite stoechiométrie LaBₓ de la ladite portion de la couche de LaBₓ soumise au traitement laser, en LaB_{y} et lui conférer une couleur ladite couleur obtenue étant déterminée par le type de source laser, ainsi que les paramètres du laser.

2. Méthode selon la revendication 1, **caractérisée en ce que** la couche est déposée par PVD (Physical Vapour Deposition).

3. Méthode selon la revendication 2 **caractérisée en ce que** la couche est déposée par pulvérisation cathodique d'une cible comprenant du LaB₆ sous la forme d'un poudre frittée et brasée sur une semelle.

4. Méthode selon la revendication 3, **caractérisée en ce que** le dépôt PVD est effectué dans un réacteur du type RF-CCP (Radio-Frequency Capacitively Coupled Plasma).

5. Méthode selon l'une quelconque des revendications précédentes, **caractérisée en ce que** la couche LaBₓ est transformée par le traitement laser en LaB_{y} avec y compris entre 9 et 12.

6. Méthode selon l'une quelconque des revendications précédentes, comprenant en outre une étape de décapage du substrat, avant le dépôt de la couche de LaBₓ.

7. Méthode selon l'une quelconque des revendications précédentes, **caractérisée en ce que** plusieurs portions adjacentes de la couche sont traitées par le laser à des puissances différentes, de manière à obtenir un motif multicolore sur le substrat.

8. Méthode selon l'une quelconque des revendications précédentes, **caractérisée en ce que** le traitement laser utilise un laser de marquage, opérant dans le domaine de l'infra-rouge, et par le balayage d'un spot du laser sur ladite au moins une portion de la surface de la couche déposée.

9. Méthode selon l'une quelconque des revendications précédentes, **caractérisée en ce que** la couleur de la portion traitée par le laser est obtenu par un changement de la stoechiométrie de la couche LaBₓ sous l'influence du laser et en fonction de la puissance de laser, ou par l'enlèvement total ou partiel de la couche LaBₓ de sorte que la couleur obtenue est déterminée par la couleur du substrat.

10. Objet décoratif à surface multicolore comportant un substrat pourvu d'une couche, **caractérisé en ce que** ladite couche comprend au moins deux portions de couleurs différentes l'une par rapport à l'autre, les portions consistant au moins à leur surface de borure de lanthane déterminé par des stoechiométries de borure de lanthane différentes dans les différentes portions.

11. Objet décoratif selon la revendication 10, caractérisé en qu'une des portions de la surface de ladite couche comprend un LaB_{y} avec y compris entre 9 et 12.

12. Objet selon la revendication 10 ou 11, **caractérisé en ce que** les portions de couleurs différentes sont des portions adjacentes.

13. Objet selon l'une des revendications 10 à 12, **caractérisé en ce que** la surface du substrat comporte en outre une ou plusieurs portions additionnelles dont la couleur est déterminée par le substrat lui-même.

14. Montre **caractérisée en ce que** la montre comprend un ou plusieurs composants selon l'une quelconque des revendications 10 à 13.

## Patentansprüche

1. Verfahren zur Herstellung einer Dekoroberfläche auf einem Substrat, **dadurch gekennzeichnet, dass** das Verfahren die folgenden Schritte umfasst:
• Aufbringen einer Schicht aus LaBₓ auf das Substrat mit einer ersten Stöchiometrie,
• Unterziehen mindestens eines Teils der Schicht LaBₓ einer Laserbehandlung, um die Stöchiometrie LaBₓ des der Laserbehandlung unterzogenen Teils der Schicht LaBₓ in LaB_{y} zu ändern und ihr eine Farbe zu verleihen, wobei die erhaltene Farbe durch den Typ der Laserquelle sowie die Parameter des Lasers bestimmt wird.

2. Verfahren nach Anspruch 1, **dadurch gekennzeichnet, dass** die Schicht durch PVD (Physical Vapour Deposition) abgeschieden wird.

3. Verfahren nach Anspruch 2, **dadurch gekennzeichnet, dass** die Schicht durch Sputtern eines Targets, das LaB₆ in Form eines gesinterten und gelöteten Pulvers enthält, auf eine Sohle aufgebracht wird.

4. Verfahren nach Anspruch 3, **dadurch gekennzeichnet, dass** die PVD-Abscheidung in einem Reaktor vom Typ RF-CCP (Radio-Frequency Capacitively Coupled Plasma) durchgeführt wird.

5. Verfahren nach einem der vorhergehenden Ansprüche, **dadurch gekennzeichnet, dass** die Schicht LaBₓ durch die Laserbehandlung in LaB_{y} mit y zwischen 9 und 12 umgewandelt wird.

6. Verfahren nach einem der vorhergehenden Ansprüche, das ferner einen Schritt zum Ätzen des Substrats vor der Abscheidung der Schicht LaBₓ umfasst.

7. Verfahren nach einem der vorhergehenden Ansprüche, **dadurch gekennzeichnet, dass** mehrere benachbarte Teile der Schicht mit dem Laser bei unterschiedlichen Leistungen bearbeitet werden, um ein mehrfarbiges Muster auf dem Substrat zu erhalten.

8. Verfahren nach einem der vorhergehenden Ansprüche, **dadurch gekennzeichnet, dass** die Laserbehandlung einen Markierungslaser verwendet, der im Infrarotbereich arbeitet, und durch das Abtasten eines Spots des Lasers über den mindestens einen Teil der Oberfläche der abgeschiedenen Schicht.

9. Verfahren nach einem der vorhergehenden Ansprüche, **dadurch gekennzeichnet, dass** die Farbe des laserbehandelten Teils durch eine Änderung der Stöchiometrie der Schicht LaBₓ unter dem Einfluss des Lasers und in Abhängigkeit von der Laserleistung oder durch vollständiges oder teilweises Entfernen der Schicht LaBₓ erzielt wird, so dass die erzielte Farbe durch die Farbe des Substrats bestimmt wird.

10. Dekorativer Gegenstand mit mehrfarbiger Oberfläche, der ein mit einer Schicht versehenes Substrat umfasst, **dadurch gekennzeichnet, dass** die Schicht mindestens zwei Teile mit voneinander verschiedenen Farben umfasst, wobei die Teile mindestens an ihrer Oberfläche aus Lanthanborid bestehen, das durch unterschiedliche Stöchiometrien von Lanthanborid in den verschiedenen Teilen bestimmt wird.

11. Dekorativer Gegenstand nach Anspruch 10, **dadurch gekennzeichnet, dass** einer der Teile der Oberfläche der Schicht einen LaB_{y} mit y zwischen 9 und 12 umfasst.

12. Gegenstand nach Anspruch 10 oder 11, **dadurch gekennzeichnet, dass** die verschiedenfarbigen Teile benachbarte Teile sind.

13. Gegenstand nach einem der Ansprüche 10 bis 12, **dadurch gekennzeichnet, dass** die Oberfläche des Substrats zusätzlich einen oder mehrere zusätzliche Teile aufweist, deren Farbe durch das Substrat selbst bestimmt wird.

14. Uhr, **dadurch gekennzeichnet, dass** die Uhr eine oder mehrere Komponenten nach einem der Ansprüche 10 bis 13 umfasst.

## Claims

1. Method for manufacturing a decorative surface on a substrate, **characterised in that** the method comprises the following steps:
• depositing a layer of LaBₓ on the substrate having a first stoichiometry,
• subjecting at least a portion of the layer of LaBₓ to a laser treatment, so as to modify said stoichiometry LaBₓ of said portion of the layer of LaBₓ subjected to the laser treatment, to LaB_{y} and give a colour, said colour obtained being determined by the type of laser source, as well as the laser parameters.

2. Method according to claim 1, **characterised in that** the layer is deposited by PVD (Physical Vapour Deposition).

3. Method according to claim 2, **characterised in that** the layer is deposited by cathode sputtering of a target comprising LaB₆ in the form of a powder sintered and brazed on a sole.

4. Method according to claim 3, **characterised in that** the PVD deposition is performed in an RF-CCP (Radio-Frequency Capacitively Coupled Plasma) type reactor.

5. Method according to any one of the preceding claims, **characterised in that** the LaBₓ layer is converted by the laser treatment into LaB_{y} where y is between 9 and 12.

6. Method according to any one of the preceding claims, further comprising a step of etching the substrate, before depositing the layer of LaBₓ.

7. Method according to any one of the preceding claims, **characterised in that** several adjacent portions of the layer are treated with the laser at different powers, so as to obtain a multicoloured pattern on the substrate.

8. Method according to any one of the preceding claims, **characterised in that** the laser treatment uses a marking laser, operating in the infrared range, and by sweeping a laser spot over at least a portion of the surface of the deposited layer.

9. Method according to any one of the preceding claims, **characterised in that** the colour of the portion treated with the laser is obtained by a change of stoichiometry of the layer LaBₓ under the influence of the laser and as a function of the laser power, or by total or partial removal of the layer LaBₓ such that the colour obtained is determined by the colour of the substrate.

10. Decorative object with a multicoloured surface including a substrate provided with a layer, **characterised in that** the layer comprises at least two portions of different colours with respect to one another, the portions consisting at least on the surface thereof of lanthanum boride determined by different lanthanum boride stoichiometries in the different portions.

11. Decorative object according to claim 10, **characterised in that** one of the portions of the surface of said layer comprises a LaB_{y} where y is between 9 and 12.

12. Object according to claim 10 or 11, **characterised in that** the portions of different colours are adjacent portions.

13. Object according to one of claims 10 to 12, **characterised in that** the surface of the substrate further includes one or more additional portions, the colour whereof is determined the substrate per se.

14. Watch **characterised in that** the watch comprises one or more components according to any one of claims 10 to 13.
